# EUROPEAN PATENT SPECIFICATION

(11) **EP 0 488 497 B1**
(45) Date of publication and mention of the grant of the patent: **02.11.1995**
(21) Application number: 91307230.2
(22) Date of filing: 06.08.1991
(51) Int. Cl.: C23C 8/80, C23C 28/00, C23C 2/02, C23C 4/02, C23C 14/02, C23C 16/02

(54) **Method of plating steel**
Verfahren zum Beschichten von Stahl
Procédé de formation d'un revêtement sur de l'acier

(30) Priority: 30.11.1990 JP 339661/90
(43) Date of publication of application: 03.06.1992
(73) Proprietor: DAIDO HOXAN INC., Sapporo-city (JP)
(72) Inventor: Yoshino, Akira, Osakasayama-shi, Osaka 589 (JP); Tahara, Masaaki, Takatsuki-shi, Osaka 569 (JP); Senbokuya, Haruo, Tondabayashi-shi, Osaka 584 (JP); Kitano, Kenzo, Kawachinagano-shi, Osaka 586 (JP)
(74) Representative: Marlow, Nicholas Simon

(56) References cited:
- EP-A- 0 352 061
- EP-A- 0 408 168
- US-A- 2 121 412
- US-A- 3 129 124
- US-A- 3 765 929

## Description

This invention relates to a method of plating steel.

Zinc hot dipping and aluminium hot dipping are widely used since a plated coat of either has excellent rust preventive properties, and since those methods are inexpensive. Plating techniques such as zinc hot dipping and aluminium hot dipping are conducted by precleaning the steel works to be plated, for example with acid, then heating them at 650 to 800°C in an annealing process in a reducing atmosphere, cooling them to near the temperature of a plating bath and then dipping them in the plating bath to form a plating coat. In such a plating process, in order to obtain a good quality plating coat, not only is sufficient precleaning of the steel articles required, but also it is preferable that oxidized scale such as SiOx, MnOx on the steel work surface layer is not formed in the annealing process under the reducing atmosphere. Works now often contain high levels of silicon, since continuous casting material is used and a high strength material is required. The silicon in the steel work changes to an oxidized scale in the annealing process in the reducing atmosphere. This scale is an obstacle to forming a plating coat, causing problems such as uneven plating and bad appearance.

In order to prevent the generation of oxidized scale, it is necessary not to convert Si and the like to oxidized scale in the annealing process in the reducing atmosphere. Generally, however, in a conventional continous treatment process, a reducing atmosphere is formed of a mixed gas composed of N₂ and H₂, and the above-mentioned steel materials are heated and cooled in this atmosphere. Since formation of an oxide of Si or Mn requires little energy, an oxide scale is readily formed. Therefore, it is impossible to prevent the above oxidation completely even if the reducing property is increased and even if the heating temperature is lowered. For example, in zinc hot dipping, steel material containing not less than 0.5% Si deteriorates in plating quality since the wettability of the plating bath is reduced due to the oxide scale formation. In aluminium hot dipping, the above problem is also caused with steel containing not less than 2% Si.

European patent application no. 0 408 168 forms part of the state of the art defined by Article 54(3) EPC for designated states DE, FR, GB, NL and discloses a method of pretreating metallic works comprising heating the work in a furnace in a fluoriding atmosphere to form a fluorided layer which is subsequently removed just prior to the plating treatment of the work.

Accordingly, it has been desired to provide a method of plating steel in which a high quality plating coat is readily formed.

According to the invention there is provided a method of plating steel according to the independent claims.

In this invention, prior to forming a plating coating on the steel work or article, they are held in an atmosphere of fluorine- or fluoride-containing gas, preferably in a heated condition, whereby oxidized scale such as SiOx and MnOx on the steel work surface is removed and at the same time a fluoride layer is formed so that the surface of the steel work is covered with the fluoride layer. The fluoride layer generally comprises a thin film of a thickness of about several tens to several thousands Å and is stable at 300°C to 600°C and prevents the new formation of oxidized scale. Since the fluoride layer is more porous than an oxide layer formed at the same temperature and has rich sublimation, it is easily removed by the action of an added flux such as chloride and/or A1 in to the plating bath of the next step. As for the removal of the fluorinated layer, steel works with the fluoride layer formed thereon are introduced into an atmosphere of an inert gas containing hydrogen or an atmosphere containing moisture (water) and heated to remove the layer, prior to being dipped in the above-mentioned plating bath. Since the steel surface is activated on removal of the fluoride layer, its conformability with a plating bath and the like is improved to achieve formation of a good quality plating coat.

This invention is described in detail below.

In this invention, steel works are charged into a heating and cooling furnace and held in an atmosphere of fluorine- or fluoride-containing gas in a heated condition, the fluoride layer resulting is removed before a plating coat is formed the steel work.

Subjects to be plated are steel works. Steel works includes various steel materials such as carbon steel or stainless steel. The form of the steel works is not limited. They may be in the form of plate or sheet, coil, or screw which is processed. The steel materials used in this invention include not only a single material but also alloys composed of iron as a main component with other metallic materials.

Fluorine- or fluoride-containing gas used for making a fluorine- or fluoride-containing gas atmosphere means a gas in which fluorine-source component is one of or a mixture of NF₃, BF₃, CF₄, HF, SF₆, F₂, CH₂F₂, CH₃F, C₂F₆, WF₆, CHF₃, SiF₄ and the like in an inert gas such as N₂.

Among the fluorine source component mentioned above, NF₃ is the most suited for practical use since it is superior in safety, reactivity, controlability, ease of handling. A mixed gas composed of, for example 1% NF₃ gas + 5% F₂ + 94% N₂ (by weight) is also useful. In such a fluorine- or fluoride-containing gas, the preferred concentration of the fluorine component such as NF₃ and the like is 1 to 15%, more preferably 2 to 7% by weight (weight standard: hereinafter the same) from the view point of efficiency. The atmosphere of fluorine- or fluoride-containing gas is formed by filling such a gas or a mixture in a predetermined space.

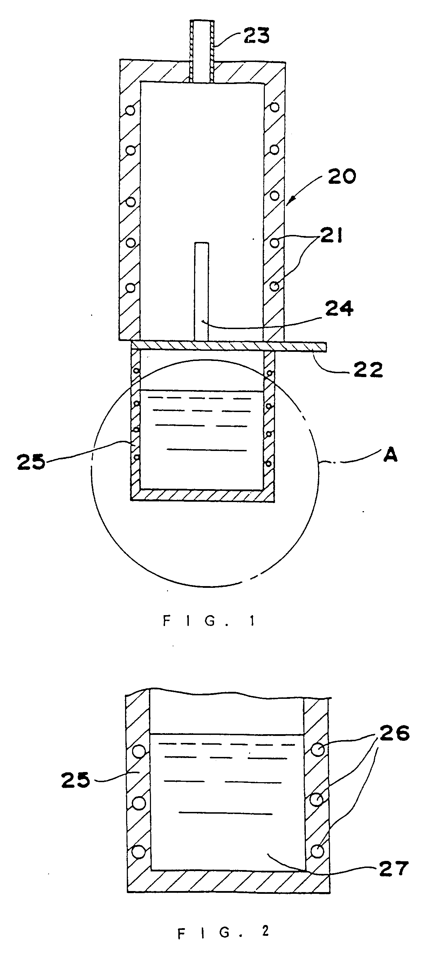

According to a preferred embodiment of the invention, the steel material is plated, for example, as follows. That is, a little idea is added to a cooling step in a conventional whole plating process. In more detail, the steel material heated to between 650°C and 750°C is cooled then introduced into an atmosphere of fluorine- and fluoride-containing gas and held therein at 300°C and 600°C for one to eight minutes, preferably two or three minutes. By holding the steel in such an atmosphere, oxides such as SiOx, and MnOx on the surface of the steel material are eliminated and a fluoride layer is formed thereon. Then the steel material with the fluoride layer formed on its surface is dipped in a plating bath such as a zinc plating bath or an aluminum plating bath or the like to form a plating coat. In this case, the fluorinated steel works are not dipped in the plating bath directly, but the works may be contacted with a mixed gas composed of hydrogen and nitrogen (H₂; 90 to 10% + N₂; the balance) to remove the fluoride layer, and then dipped in the plating bath. In a series of process, the amount of NF₃ to obtain a good quality plating coat is preferably about 50g to 700g per ton of the steel material.
In the drawings, Fig. 1 shows a cross-sectional view of an example of a treatment furnace used in this invention,
Fig. 2 shows a partially enlarged view of a part A of Figure 1, and
Fig. 3, 4 and 5 show depth-direction elemental analysis curves by SIMS.

### EXAMPLE 1(a)

An experimental heat treatment furnace 1 as shown in Fig. 1 was used. In the figure, reference numeral 20 is a furnace body having adiabatic walls, 21 are heaters disposed in the wall of the furnace body 20 and 22 is a slidable door disposed at the bottom of the furnace body 20. The door 22 slides right and left as seen in Fig. 1. At the ceiling of the furnace body 20 is connected a conduit 23 for introducing a gas into the furnace 20. The reference numeral 24 indicates steel articles to be treated. Under the furnace 20 is disposed a zinc pot furnace 25 which is separated by the slidable door 22. In the zinc pot furnace 25, an induction coil 26 is disposed in the surrounding walls as shown in Fig. 2, and liquid zinc at 480°C is filled therein.

In this furnace, a few samples of steel works (cold-rolled steel material: 1% Si, 0.2% Mn) were heated to 750°C in an N₂ atmosphere, then cooled to 350°C, then a fluoride containing gas (N₂ + 5% NF₃) was blown into the furnace for one minute and held therein for two to five minutes. After that, N₂ gas was blown in, the temperature was raised to 500°C and then one of the samples was taken out of the furnace for elemental analysis. The rest of the samples were transferred into the zinc pot furnace 25 by opening the slidable door 22 and dipped in a zincing bath to coat them with zinc. After plating with zinc, they were taken out of the furnace 25 and at the same time blown with N₂ gas, then cooled and dried, whereby plated samples were produced.

### EXAMPLE 1(b)

This was conducted as Example 1(a), except that after supplying the fluoride-containing gas composed of N₂ + 5% NF₃ into the heat treatment furnace and holding the samples for two to five minutes therein, a mixed gas composed of N₂ + 25% H₂ was supplied therein and under the atmosphere the samples were heated to 500°C and held for ten minutes. Then the samples were transferred into the zinc pot furnace 25 to galvanize them. The same plated samples were produced as mentioned above.

### EXAMPLE 2

Steel samples were heated to 750°C in an N₂ atmosphere, cooled to 500°C and held in an atmosphere of fluorine- or fluoride-containing gas having the same composition as in Example 1(a). This apart, plated samples were made as in Example 1.

### EXAMPLE 3

A mixed gas composed of 1% NF₃ + 5% F₂ + 94% N₂ was used as the fluorine- or fluoride-containing gas. That apart, plated samples were made as in Example 1(a).

### COMPARATIVE EXAMPLE

The same samples used in the Example 1 were used and they were heated at 750°C in an N₂ + 50% H₂ atmosphere, then cooled to 500°C and dipped in a zincing bath as in Example 1 without fluorination. This apart, plated samples were obtained in the Example 1.

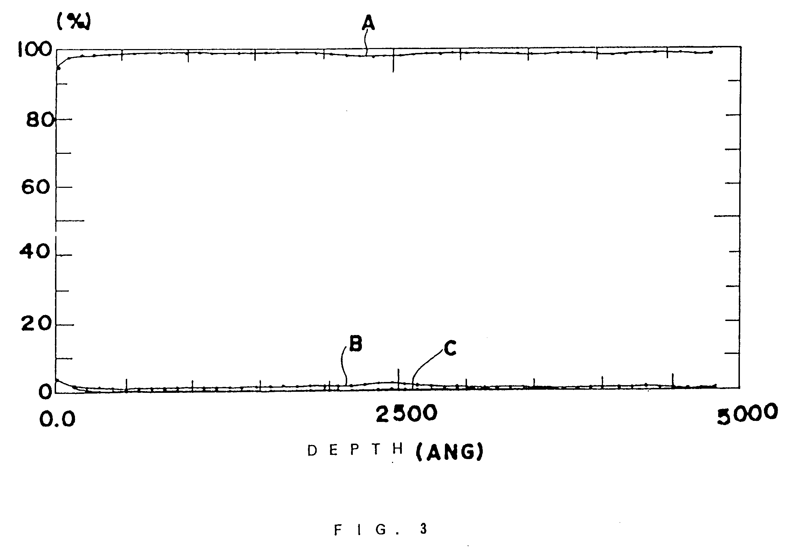

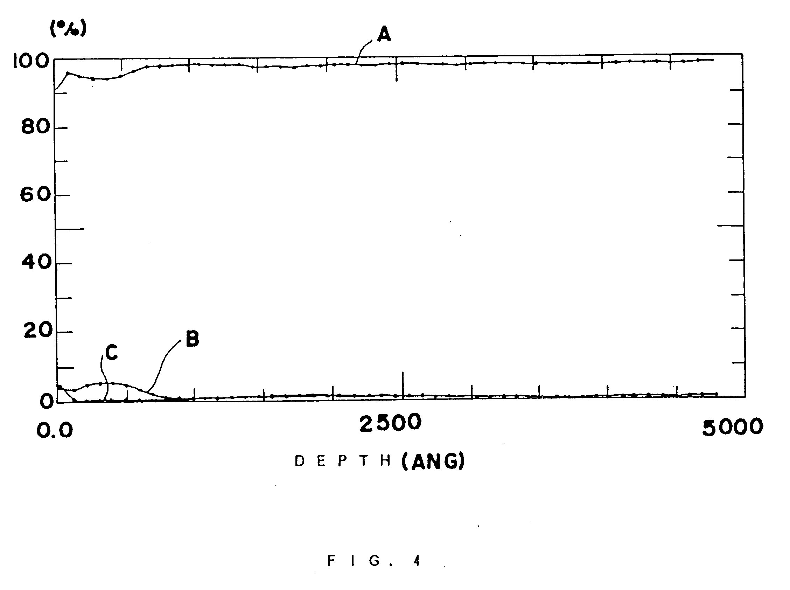

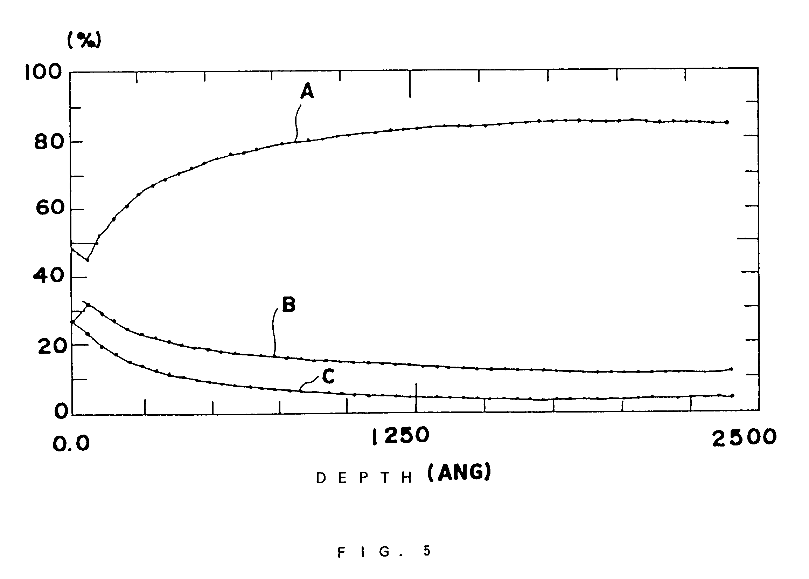

An elemental analysis of the depth in the surface layer part was conducted by SIMS (secondary ion mass spectrometery) against an unplated sample (what are in a sample immediately before plating) obtained in the Examples 1(a), 2 and the Comparative Example. The results are shown in Figs. 3, 4 and 5. In these Figures, straight line A shows Fe, straight line B; Si, straight line C; Mn. Fig. 3 corresponds to Example 1(a), Fig. 4 to Example 2 and Fig. 5 to the Comparative Example. That is, "concentration" of Si and/or Mn (Concentrating degree of Si and/or Mn is relatively high.) was not seen in the outside surface layer part in Examples 1 and 2 as is clearly seen in Figs. 3 and 4. On the contrary, in the Comparative Example shown in Fig. 5, oxidation of the outside surface layer occurred to form oxides such as SiOx and MnOx on the surface layer, whereby the concentration of Si and Mn in the surface layer becomes relatively high. We define this condition as "concentration."

A bending part was examined by conducting an adhesion bending test for examing the adhesiveness of the plating coat on each sample produced in the Examples and the Comparative Examples. As a result, blistering of the plating coat was not seen on the bending part in Examples 1(a), 1(b) and 2, while extensive blistering and bad adhesiveness of the plating coat were observed on the bending part of the Comparative Example. The sample obtained from Example 3 showed the same structure and the same plating coat properties as those obtained from Example 1(a).

It is apparent from the results given above that it is possible, by use of the invention, to conduct high quality plating such as a hot zinc dipping of high Si content steel materials which are hard to plate conventionally, and that it is also possible to produce steel sheet or steel plate of high strength. In addition, the use of H₂ gas to provide a reducing atmosphere for annealing may be largely or wholly avoided, giving a saving in cost. In the Examples, an experimental furnace apparatus was used for plating, but it is possible to carry out the invention by utilizing ready-made equipment by modifying cooling step equipment of an actual continous hot zinc dipping line.

As mentioned above, in methods of plating steel according to the invention, since a plating coat is formed on the steel surface after holding the steel material in an atmosphere of fluorine- or fluoride-containing gas in a heated condition, surface oxide layer is removed and a fluoride layer is formed thereon to cover and protect the surface. The steel material with the fluoride layer formed is dipped in a plating bath directly or introduced in an inert gas atmosphere containing hydrogen and heated to thereby decompose and remove the fluoride layer, and then dipped in the plating bath. In the case of dipping in the plating bath directly, the fluoride layer is decomposed and removed by the action of an added flux such as chloride and A1 added to the plating bath. In the case of dipping in the plating bath after introducing the steel work into the hydrogen-containing inert gas atmosphere, since the fluoride layer is removed prior to dipping in the plating bath, the plating treatment can be done swiftly. In this way the fluoride layer is removed and an activated steel surface is exposed. The plating coat is well-adhered and formed preferably on the activated steel surface to give high quality plating.

## Claims (Claims for the following Contracting State(s): AT, CH, DK, ES, IT, LI, SE)

1. A method of plating steel to form a plating coat on a steel work or article comprising;
exposing the steel work or article to an atmosphere of fluorine- or fluoride-containing gas to form a fluorided layer;
removing the fluorided layer; and
forming a plating coat by a hot-dip plating process.

2. A method according to claim 1 in which the fluorided steel work or article is exposed to a reducing atmosphere to remove the fluoride layer before the hot-dip plating step.

3. A method according to claim 1 in which the fluoride layer is removed by adding a flux to the plating bath.

4. A method according to any preceding claim, in which the fluorine- or fluoride-containing gas comprises an inert gas and at least one of NF₃, BF₃, CF₄, HF, SF₆, F₂, CH₂F₂, CH₃F, C₂F₆, WF₆, CHF₃ and SiF₄.

5. A method according to any preceding claim in which the fluorine- or fluoride-containing gas comprises from 1% to 15%, preferably from 2% to 7%, by weight of the fluorine- or fluoride-containing component.

6. A method according to any preceding claim in which the fluorine- or fluoride-containing gas is at from 300°C to 600°C.

7. A method according to any preceding claim in which the work or article is exposed to the fluorine- or fluoride-containing atmosphere for from 1 minute to 8 minutes, preferably for from 2 minutes to 3 minutes.

8. A method according to any preceding claim in which from 50g to 700g NF₃ is used per ton of steel.

## Claims (Claims for the following Contracting State(s): DE, FR, GB, NL)

1. A method of plating steel to form a plating coat on a steel work or article comprising:
exposing the steel work or article to an atmosphere of fluorine- or fluoride-containing gas to form a fluorided layer;
removing the fluorided layer; and
forming a plating coat by a hot-dip plating process, characterised in that the fluorine- or fluoride-containing gas is NF₃ and 50g to 700g NF₃ is used per ton of steel.

2. A method according to claim 1 in which the fluorided steel work or article is exposed to a reducing atmosphere to remove the fluoride layer before the hot-dip plating step.

3. A method according to claim 1 in which the fluoride layer is removed by adding a flux to the plating bath.

4. A method according to any preceding claim in which the fluorine- or fluoride-containing gas comprises from 1% to 15%, preferably from 2% to 7%, by weight of the fluorine- or fluoride-containing component.

5. A method according to any preceding claim in which the fluorine- or fluoride-containing gas is at from 300°C to 600°C.

6. A method according to any preceding claim in which the work or article is exposed to the fluorine- or fluoride-containing atmosphere for from 1 minute to 8 minutes, preferably for from 2 minutes to 3 minutes.

## Patentansprüche (Patentansprüche für folgende(n) Vertragsstaat(en): AT, CH, DK, ES, IT, LI, SE)

1. Verfahren zum Beschichten von Stahl, um eine Überzugsschicht auf einem Stahlwerkstück oder -gegenstand zu bilden, umfassend:
Aussetzen des Stahlwerkstückes oder -gegenstandes einer Atmosphäre von Fluor- oder fluoridhaltigem Gas, um eine fluorierte Schicht zu bilden;
Entfernen der fluorierten Schicht und Bilden einer Überzugsschicht durch ein Schmelztauchverfahren.

2. Verfahren nach Anspruch 1, bei dem das fluorierte Stahlwerkstück oder der Stahlgegenstand einer reduzierenden Atmosphäre ausgesetzt wird, um die Fluoridschicht vor dem Schmelztauchschritt zu entfernen.

3. Verfahren nach Anspruch 1, bei dem die Fluoridschicht durch Zusatz eines Flußmittels zum Überzugsbad entfernt wird.

4. Verfahrend nach irgendeinem ver vorhergehenden Ansprüche, bei dem das Fluor- oder fluoridhaltige Gas ein inertes Gas und wenigstens eines von NF₃, BF₃, CF₄, HT, SF₆, F₂, CH₂F₂, CH₃F, C₂F₆, WF₆, CHF₃ und SiF₄ enthält.

5. Verfahren nach irgendeinem der vorhergehenden Ansprüche, bei dem das Fluor- oder fluoridhaltige Gas von 1 bis 15 Gew.-%, vorzugsweise von 2 bis 7 Gew.-%, der fluor- oder fluoridhaltigen Verbindung enthält.

6. Verfahren nach irgendeinem der vorhergehenden Ansprüche, bei dem das fluor- oder fluoridhaltige Gas auf Temperaturen von 300 bis 600°C ist.

7. Verfahren nach irgendeinem der vorhergehenden Ansprüche, dadurch gekennzeichnet, daß das Stahlwerkstück oder der Stahlgegenstand der fluor- oder Fluoridhaltigen Atmosphäre Für 1 bis 8 Minuten, vorzugsweise für 2 bis 3 Minuten, ausgesetzt wird.

8. Verfahren nach irgendeinem der vorhergehenden Ansprüche, bei dem 50 bis 700 g NF₃ pro Tonne Stahl verwendet wird.

## Patentansprüche (Patentansprüche für folgende(n) Vertragsstaat(en): DE, FR, GB, NL)

1. Verfahren zum Beschichten von Stahl, um eine Überzugsschicht auf einem Stahlwerkstück oder -gegenstand zu bilden, umfassend:
Aussetzen des Stahlwerkstückes oder -gegenstandes einer Atmosphäre von fluor- oder fluoridhaltigem Gas, um eine fluorierte Schicht zu bilden;
Entfernen der fluorierten Schicht und Bilden einer Überzugsschicht durch ein Schmelztauchverfahren,
dadurch gekennzeichnet, daß das fluor- oder fluoridhaltige Gas NF₃ ist und 50 bis 700 g NF₃ pro Tonne Stahl verwendet wird.

2. Verfahren nach Anspruch 1, bei dem das fluorierte Stahlwerkstück oder der Stahlgegenstand einer reduzierenden Atmosphäre ausgesetzt wird, um die Fluoridschicht vor dem Schmelztauchschritt zu entfernen.

3. Verfahren nach Anspruch 1, bei dem die Fluoridschicht durch Zusatz eines Flußmittels zum Überzugsbad entfernt wird.

4. Verfahren nach irgendeinem der vorhergehenden Ansprüche, bei dem das fluor- oder fluoridhaltige Gas von 1 bis 15 Gew.-%, vorzugsweise von 2 bis 7 Gew.-%, der fluor- oder fluoridhaltigen Verbindung enthält.

5. Verfahren nach irgendeinem der vorhergehenden Ansprüche, bei dem das fluor- oder fluoridhaltige Gas auf Temperaturen von 300 bis 600°C ist.

6. Verfahren nach irgendeinem der vorhergehenden Ansprüche, dadurch gekennzeichnet, daß das Stahlwerkstück oder der Stahlgegenstand der fluor- oder fluoridhaltigen Atmosphäre für 1 bis 8 Minuten, vorzugsweise für 2 bis 3 Minuten, ausgesetzt wird.

## Revendications (Revendications pour l'(les) Etat(s) contractant(s) suivant(s): AT, CH, DK, ES, IT, LI, SE)

1. Procédé de formation d'un revêtement sur de l'acier pour constituer un revêtement de placage sur un ouvrage ou article en acier,comprenant
l'exposition de l'ouvrage ou article en acier à un gaz contenant du fluor ou du fluorure pour former une couche fluorurée ;
l'élimination de la couche fluorurée ; et
la formation d'un revêtement par un procédé de placage à chaud.

2. Procédé selon la revendication 1, dans lequel l'ouvrage ou article en acier fluoruré est exposé à une atmosphère réductrice pour éliminer la couche de fluorure avant l'étape de placage à chaud.

3. Procédé selon la revendication 1, dans lequel la couche de fluorure est éliminée par addition d'un flux au bain de placage.

4. Procédé selon l'une quelconque des revendications précédentes, dans lequel le gaz contenant du fluor ou du fluorure comprend un gaz inerte et au moins un des gaz NF₃, BF₃, CF₄, HF, SF₆, F₂, CH₂F₂, CH₃F, C₂F₆, WF₆, CHF₃ et SiF₄.

5. Procédé selon l'une quelconque des revendications précédentes, dans lequel le gaz contenant du fluor ou du fluorure comprend de 1 % à 15 %, de préférence de 2 % à 7 % en poids de composant contenant du fluor ou du fluorure.

6. Procédé selon l'une quelconque des revendications précédentes, dans lequel le gaz contenant du fluor ou du fluorure est à une température comprise entre 300 °C et 600 °C.

7. Procédé selon l'une quelconque des revendications précédentes, dans lequel l'ouvrage ou article est exposé à l'atmosphère contenant du fluor ou du fluorure pendant 1 minute à 8 minutes, de préférence pendant 2 minutes à 3 minutes.

8. Procédé selon l'une quelconque des revendications précédentes, dans lequel on utilise de 50 g à 700 g de NF₃ par tonne d'acier.

## Revendications (Revendications pour l'(les) Etat(s) contractant(s) suivant(s): DE, FR, GB, NL)

1. Procédé de formation d'un revêtement sur de l'acier pour constituer un revêtement de placage sur un ouvrage ou article en acier, comprenant
l'exposition de l'ouvrage ou article en acier à une atmosphère de gaz contenant du fluor ou du fluorure pour former une couche fluorurée ;
l'élimination de la couche fluorurée ; et
la formation d'un revêtement par un procédé de placage à chaud, caractérisé en ce que le gaz contenant du fluor ou du fluorure est du NF₃ et en ce qu'on utilise de 50 g à 700 g de NF₃ par tonne d'acier.

2. Procédé selon la revendication 1, dans lequel l'ouvrage ou article en acier est exposé à une atmosphère réductrice pour éliminer la couche de fluorure avant l'étape de placage à chaud.

3. Procédé selon la revendication 1, dans lequel la couche de fluorure est éliminée par addition d'un flux au bain de placage.

4. Procédé selon l'une quelconque des revendications précédentes, dans lequel le gaz contenant du fluor ou du fluorure comprend de 1 % à 15 %, de préférence de 2 % à 7 % en poids de composant contenant du fluor ou du fluorure.

5. Procédé selon l'une quelconque des revendications précédentes, dans lequel le gaz contenant du fluor ou du fluorure est à une température comprise entre 300 °C et 600 °C.

6. Procédé selon l'une quelconque des revendications précédentes, dans lequel l'ouvrage ou article est exposé à l'atmosphère contenant du fluor ou du fluorure pendant 1 minute à 8 minutes, de préférence pendant 2 minutes à 3 minutes.
